# EUROPÄISCHE PATENTSCHRIFT

(11) **EP 1 075 629 B1**
(45) Veröffentlichungstag und Bekanntmachung des Hinweises auf die Patenterteilung: **02.01.2002**
(21) Anmeldenummer: 99922126.0
(22) Anmeldetag: 26.04.1999
(51) Int. Cl.: F24J 2/38, G01S 3/786

(54) **THERMOHYDRAULISCHE SONNENNACHFÜHREINRICHTUNG**
THERMOHYDRAULIC SUN-TRACKING DEVICE
DISPOSITIF THERMOHYDRAULIQUE DE POURSUITE DU SOLEIL

(30) Priorität: 30.04.1998 DE 19819337
(43) Veröffentlichungstag der Anmeldung: 14.02.2001
(73) Patentinhaber: Zentrum Für Sonnenenergie- und Wasserstoff-Forschung Baden-Württemberg, 70565 Stuttgart (DE)
(72) Erfinder: KLOTZ, Fritz, Harald, D-73635 Rudersberg (DE)
(74) Vertreter: Patentanwälte Ruff, Wilhelm, Beier, Dauster & Partner
(86) Internationale Anmeldenummer: EP9902793
(87) Internationale Veröffentlichungsnummer: WO9957493

(56) Entgegenhaltungen:
- DE-A- 3 617 171
- DE-A- 4 208 255
- DE-A- 4 221 896
- FR-A- 2 446 931
- US-A- 4 089 323

## Beschreibung

Die Erfindung bezieht sich auf eine thermohydraulische Sonnennachführeinrichtung nach dem Oberbegriff des Anspruchs 1. Einrichtungen dieser Art dienen dazu, das schwenkbeweglich gelagerte Sonnennutzelement, z.B. einen photovoltaisch aktiven Sonnenkollektor, selbstätig optimal auf den jeweiligen Sonnenstand auszurichten, d.h. diesem nachzuführen. Diese nach thermohydraulischem Prinzip arbeitenden Einrichtungen gehören zur Klasse der sogenannten passiven Solarnachführungen, die ohne zusätzlichen Energie- und Steuerungsaufwand auskommen, im Gegensatz zu den sogenannten aktiven Solarnachführungen, die Schrittmotoren, eine Kontrollelektronik und dergleichen enthalten, und zum Beispiel elektronisch nach einem kalendarischen Prinzip arbeiten. Passive Nachführsysteme werden folglich insbesondere in zivilisationsfernen, entlegenen Gebieten eingesetzt.

Die thermohydraulischen Solarnachführsysteme unterteilen sich in solche, die nach dem Schwerkraftprinzip arbeiten, und solche, die mit hydrostatisch betätigten Stellzylindern arbeiten. Die Solarnachführung nach dem Schwerkraftprinzip hat den Vorteil, daß kein Stellzylinder benötigt wird und das entsprechende Ausfallrisiko durch Schäden oder Leckagen entfällt. Systeme nach dem Schwerkraftprinzip lassen sich daher erforderlichenfalls so auslegen, daß sie über Jahre oder sogar Jahrzehnte wartungsfrei bleiben. Nachführsysteme mit Hydrostatik-Stellzylindern haben hingegen den Vorteil, daß die Stellkraftrichtung unabhängig von der Schwerkraftrichtung gewählt werden kann und sich unter sonst gleichen Bedingungen höhere Rückstellkräfte in die Sollposition erzielen lassen, was die Nachführgenauigkeit erhöhen kann und die Stabilität gegenüber Windlasten steigert.

Die Systeme beinhalten typischerweise zwei miteinander in Fluidverbindung stehende Absorbereinheiten mit einem in ihnen enthaltenen Arbeitsfluid sowie eine lichtreflektierende und/oder lichtabschattende Lichtsteuereinheit, die sich mit dem Sonnennutzelement verschwenkt. Die Lichtsteuereinheit ist so ausgelegt, daß sie eine symmetrische Sonnenlichtbestrahlung der beiden Absorbereinheiten bewirkt, wenn sich das Sonnennutzelement optimal ausgerichtet in der gewünschten Sollposition befindet, während sie eine asymmetrische Sonnenlichtbestrahlung der Absorbereinheiten bewirkt, wenn sich das Sonnennutzelement aus seiner Sollposition herausbewegt hat. Die asymmetrische Bestrahlung hat eine entsprechende Asymmetrie der Temperatur des durch Sonnenlichteinfall auf die jeweilige Absorbereinheit erwärmbaren Arbeitsfluides zur Folge, so daß sich dessen Fluiddruck in der stärker bestrahlten Absorbereinheit erhöht.

Bei den Nachführsystemen nach dem Schwerkraftprinzip wird dafür gesorgt, daß sich die Absorbereinheit, welche sich in sonnenzugewandter Richtung und dadurch mit einer entgegen der Schwerkraft gerichteten Komponente verschwenkt, weniger stark bestrahlt wird und sich folglich weniger stark erwärmt als die gegenüberliegende Absorbereinheit. Der resultierende Druckunterschied führt zu einem Arbeitsfluidtransport von der Absorbereinheit auf der nach unten verschwenkten Seite zur anderen Absorbereinheit, die dadurch mit ihrer Füllung schwerer wird und das Sonnennutzelement auf diese Weise wieder in die optimal ausgerichtete Gleichgewichtslage zurückbringt. Dazu sind die Absorbereinheiten häufig so angeordnet, daß sie sich bezüglich der zugehörigen Drehachse des Sonnennutzelementes gegenüberliegen. Bei den Nachführsystemen mit Hydrostatik-Stellzylinder bewirkt der resultierende Druckunterschied in den beiden verschieden stark erwärmten Absorberrohren eine rückstellende Betätigung des Stellzylinders.

Eine allgemeine Schwierigkeit passiver Solarnachführungen stellen die Ostrückführung am Morgen und eine Westhinführung am Nachmittag dar. Unter Ostrückführung wird die selbstätige Rückstellung des Sonnennutzelementes von der nachmittäglichen bzw. abendlichen, nach Westen ausgerichteten Stellung in die morgendliche, nach Osten gerichtete Stellung verstanden. Unter dem Problem der Westhinführung wird der Effekt verstanden, daß das Sonnennutzelement, wenn die Sonneneinstrahlung aufgrund von Bewölkung im Laufe des Vormittags verschwindet, in einer östlichen Ausrichtung stehenbleibt und die Sonneneinstrahlung erst geraume Zeit später aus westlicher Richtung wieder einsetzt, was einen großen anfänglichen Fehlwinkel in der Ausrichtung des Sonnennutzelementes bedeutet. Um diese Problemsituationen zu bewältigen, muß die Nachführeinrichtung folglich auf einen ausreichend großen Fangwinkelbereich ausgelegt sein, innerhalb dem sie die Nachführung des Sonnennutzelementes in seine momentan optimale Sollposition zuverlässig gewährleistet.

Eine auf dem Schwerkraftprinzip beruhende Einrichtung der eingangs genannten Art ist in der Patentschrift US 4 275 712 offenbart. Beim dortigen System ist die Lichtsteuereinheit von je einem Abschattungselement für jede Absorbereinheit gebildet, das so geformt und angeordnet ist, daß in der Sollposition der dort als Sonnennutzelement verwendeten, trogförmigen Konzentratorzellenanordnung die beiden Absorbereinheiten symmetrisch partiell vor direktem Sonnenlichteinfall abgeschattet sind, während bei Abweichungen von der Sollposition die sonnenzugewandt verschwenkte Absorbereinheit stärker abgeschattet und daher weniger stark erwärmt wird als die andere Absorbereinheit. Wenn der Sonnenkollektor am Abend in einer ungefähr westlich ausgerichteten Stellung stehen bleibt, sind die Absorberrohre am nächsten Morgen durch die Abschattelemente vor Sonnenlichteinfall abgeschirmt. Um die sich daraus ergebende Problematik der Ostrückführung und gegebenenfalls auch der Westhinführung zu bewältigen, beinhaltet die Absorbereinheit eine mit dem westlichen Absorberrohr in wärmeleitender Verbindung stehende, nach Osten gewandte Absorberplatte. In einem weiteren, dort gezeigten Beispiel beinhaltet die Absorbereinheit neben einer nach Osten gewandten Absorberplatte zusätzlich eine nach Westen gewandte Absorberplatte, und statt Absorberrohren sind am Sonnenkollektor reine Fluidspeicherrohre vorgesehen, die selbst keinem Sonnenlichteinfall unterliegen. Das östliche Speicherrohr steht mit der westlichen Absorberplatte und das westliche Speicherrohr mit der östlichen Absorberplatte in wärmeleitender Verbindung.

In der Patentschrift US 4 476 854 ist eine weitere Einrichtung der eingangs genannten Art beschrieben, die auf dem Schwerkraftprinzip beruht und zwei Absorberrohre mit unterschiedlichen Volumina beinhaltet. Dieses System arbeitet nach einem Gasfederprinzip, wozu es in definierter Weise mit einem geeigneten Arbeitsfluid gefüllt ist. Die Gasfederwirkung soll auch eine selbstätige Ostrückführung ermöglichen. Ein Dämpfungszylinder sorgt für eine gewünschte Dämpfung der Nachführbewegung und stabilisiert das System gleichzeitig gegen Windlasteinwirkung.

In der Patentschrift DE 42 08 255 C2 ist eine Einrichtung der eingangs genannten Art beschrieben, die mit einem Hydrostatik-Stellzylinder arbeitet. Die dortige Lichtsteuereinheit besteht aus je einer Reflektor- und Abschatteinheit für zwei gegenüberliegende Absorberrohre. Die Reflexions- und Abschatteinheit umgibt das jeweilige Absorberrohr im wesentlichen auf dessen dem Sonnennutzelement zugewandten Seite, während sie von der nutzelementabgewandten Seite einfallendes Sonnenlicht in einem vom Einfallswinkel abhängigen Maß auf das Absorberrohr reflektiert und so neben dem direkten Lichteinfall für eine zusätzliche Bestrahlung des Absorberrohres sorgt. Dabei wird das sonnenzugewandt verschwenkte Absorberrohr stärker bestrahlt und erwämt als das andere, sonnenabgewandt verschwenkte Absorberrohr, und die entstehende Druckdifferenz betätigt den mit den Absorberrohren in Fluidverbindung stehenden Stellzylinder in rückstellendem Sinn. Wegen der stärkeren Bestrahlung des sich sonnenzugewandt verschwenkenden Absorberrohres eignet sich diese Anordnung nicht direkt für eine Nachführung nach dem Schwerkraftprinzip. Durch die zusätzliche Nutzung von auf die Absorberrohre reflektiertem Sonnenlicht werden bei sonst gleicher Systemauslegung höhere Fluiddruckdifferenzen und damit höhere Rückstellkräfte ermöglicht als bei nur auf direkter Absorberrohrbestrahlung beruhenden Systemen, was die Nachführgenauigkeit verbessert. Die Reflektor- und Abschatteinheiten sind dort so gestaltet, dass sie in der Nutzelement-Sollposition die Absorberrohre symmetrisch einerseits gegenüber einem Teil des direkten Sonnenlichteinfalls abschatten und andererseits zusätzlich mit reflektiertem Licht bestrahlen, so dass annähernd die Bestrahlungsintensität erreicht wird, die einer ganzflächigen direkten Bestrahlung entspricht. Innerhalb eines Bereichs von etwa ±10° um die Nutzelement-Sollposition ändert sich die Bestrahlungsintensität von ungefähr null bis auf etwa das Doppelte der direkten ganzflächigen Bestrahlungsintensität. Dies entspricht einer Änderungsrate von ca. 0,1/Grad, wobei diese Änderungsrate ein Maß für die erzielbare Nachführgenauigkeit ist.

Eine weitere Einrichtung der eingangs genannten Art, wie sie in der Patentschrift US 4.089.323 offenbart ist, umfasst zwei parallel versetzt angeordnete, röhrenförmige Absorbereinheiten, die vor direktem Sonnenlichteinfall durch je ein zugeordnetes Abschattungselement geschützt sind. Den Absorbereinheiten sind Reflexionsflächen einer gemeinsamen Reflektoreinheit dergestalt zugeordnet, dass kein reflektiertes Sonnenlicht auf die Absorbereinheiten fällt, solange die Reflektoreinheit innerhalb eines vorgebbaren Toleranzbereiches von z.B. ±5° um eine Sollposition orientiert ist, in welcher die Symmetrielängsachse der Reflektoreinheit parallel zur Sonnenlichteinfallsrichtung ist. Sobald der zugehörige Fehlwinkel den Toleranzwert von z.B. 5° überschreitet, trifft je nach Abweichungsrichtung das von der einen oder anderen Reflektorhälfte reflektierte Licht auf die zugehörige Absorbereinheit, während das von der jeweils anderen Reflektorhälfte reflektierte Licht weiterhin nicht auf deren zugehörige Absorbereinheit trifft. Durch die dortige Reflektorflächengestaltung ergibt sich eine sprunghafte Änderung der Intensität des auf die jeweilige Absorbereinheit reflektierten Lichtes bei Überschreiten des Toleranzwertes, während bei Fehlwinkeln innerhalb des Toleranzbereiches keine Lichtreflexion auf die beiden Absorbereinheiten auftritt.

Der Erfindung liegt als technisches Problem die Bereitstellung einer thermohydraulischen Sonnennachführeinrichtung der eingangs genannten Art zugrunde, die eine relativ hohe Nachführgenauigkeit und/oder eine zuverlässige Ostrückführung und/oder Westhinführung ermöglicht und sich insbesondere auch für Systeme nach dem Schwerkraftprinzip eignet.

Die Erfindung löst dieses Problem durch die Bereitstellung einer thermohydraulischen Sonnennachführung mit den Merkmalen des Anspruchs 1 oder mit den Merkmalen des Anspruchs 7.

Bei der Einrichtung nach Anspruch 1 weist die Lichtsteuereinheit für eine oder bevorzugt beide Absorbereinheiten je ein Feineinstellreflektorelement auf, das sich sonnenstandsabhängig verschwenkt und so ausgelegt ist, dass es einfallendes Sonnenlicht innerhalb eines vergleichsweise geringen Feineinstellwinkelbereichs von höchstens 4° am einen Intervallendpunkt vollständig oder jedenfalls weitestgehend vollständig an der zugehörigen Absorbereinheit vorbeireflektiert, am anderen Intervallendpunkt hingegen vollständig oder jedenfalls weitestgehend vollständig auf die zugehörige Absorbereinheit reflektiert, wobei sich die Nutzelement-Sollposition innerhalb dieses Feineinstellbereiches befindet. Mit diesem Feineinstellreflektorelement wird folglich ein hoher Einstellgradient schon bei geringfügigen Nutzelement-Fehlpositionierungen im Bereich von höchstens einigen wenigen Winkelgraden, bevorzugt im Bereich von höchstens einigen Zehntel Winkelgraden bereitgestellt, woraus eine entsprechend hohe Nachführgenauigkeit schon bei sehr kleinen Abweichungen des Systems von der Sollposition resultiert.

Bei einer nach Anspruch 2 weitergebildeten Einrichtung ist das Feineinstellreflektorelement speziell so ausgelegt, daß es bei Herausbewegen des Sonnennutzelementes aus seiner Sollposition um höchstens etwa 0,5° zusätzliches Sonnenlicht auf die zugehörige Absorbereinheit mit einer Bestrahlungsintensität reflektiert, die mindestens 50% der direkten Einstrahlungsintensitität beträgt. Entsprechend stark erhöht sich die Temperatur und damit die Druckdifferenz zwischen den beiden gegenüberliegenden Absorbereinheiten und als Folge davon die Nachführgenauigkeit des Systems schon innerhalb dieses kleinen Fehlwinkelbereichs.

Bei einer nach Anspruch 3 weitergebildeten Einrichtung erhöht das Feineinstellreflektorelement die Sonnenlichtreflexion auf die zugehörige Absorbereinheit in der sonnenabgewandten Schwenkrichtung. Damit eignet sich diese Einrichtung direkt für Schwerkraftnachführsysteme.

Eine nach Anspruch 4 weitergebildete Einrichtung besitzt für eine und vorzugsweise beide Absorbereinheiten je ein Grobeinstellreflektorelement, das für eine zusätzliche Bestrahlung der zugehörigen Absorbereinheit durch darauf reflektiertes Sonnenlicht in einem Grobeinstellwinkelbereich sorgt, der sich über größere Nutzelementfehlwinkel erstreckt als der Feineinstellwinkelbereich. Damit wird eine Rückkehr des Sonnennutzelementes in seine Sollposition auch aus größeren Fehipositionen heraus ermöglicht, insbesondere eine Westhinführung nach Zeiträumen mit mehrstündiger Unterbrechung der Sonneneinstrahlung. In einer weiteren Ausgestaltung dieser Maßnahme ist das jeweilige Grobeinstellreflektorelement gemäß Anspruch 5 so ausgelegt, daß es zusätzliches Sonnenlicht bis zu Fehlwinkelstellungen von mindestens 70° auf die zugehörige Absorbereinheit reflektiert.

In weiterer Ausgestaltung gemäß Anspruch 6 dient das Grobeinstellreflektorelement zusätzlich als Abschattelement in Fehlstellungen, die auf der dem Grobeinstellwinkelbereich gegenüberliegenden Seite der Nutzelement-Sollposition liegen. Dies unterstützt die Erzielung der gewünschten Temperaturdifferenz zwischen den beiden Absorbereinheiten in solchen Fehlstellungen, indem neben der zusätzlichen Bestrahlung der einen Absorbereinheit durch reflektiertes Licht vom zugeordneten Feineinstell- und/oder Grobeinstellreflektorelement gleichzeitig die Bestrahlung der anderen Absorbereinheit durch die Abschattungswirkung des zugehörigen Grobeinstellreflektorelementes verringert wird. Wenn die Abschattwirkung bei sonnenzugewandtem Entfernen aus der Sollposition und die zusätzliche Reflexionslichtbestrahlung bei entgegengesetzten, sonnenabgewandten Fehlstellungen einsetzt, eignet sich die Einrichtung direkt als Schwerkraftnachführsystem.

Bei der Nachführeinrichtung nach Anspruch 7 weist die Lichtsteuereinheit für eine oder vorzugsweise beide Absorbereinheiten ein sich sonnenstandsabhängig verschwenkendes Rückholreflektorelement auf, das so ausgelegt ist, daß es einfallendes Sonnenlicht dann auf die zugehörige Absorbereinheit reflektiert, wenn das Sonnennutzelement in einem Fehlwinkelbereich zwischen 90° und 180° positioniert ist, d.h. rückwärtig beschienen wird. Durch die in diesem rückwärtigen Stellungsbereich vom Rückholreflektorelement bewirkte Absorberelementbestrahlung mit reflektiertem Licht läßt sich in den beiden Absorbereinheiten auch in diesen großen Fehlstellungen eine Temperatur- und damit Druckdifferenz des Arbeitsfluids erzeugen, die zur Rückholung des Sonnennutzelementes in seine Sollposition ausreicht. Die dergestalt ausgelegte Nachführeinrichtung erlaubt somit insbesondere eine zuverlässige morgendliche Ostrückführung aus westwärts liegenden Stellungen. Analog läßt sich bei dieser Einrichtung auch eine Westhinführung am Nachmittag aus einer nach Osten gewandten Stellung erzielen. Die Einrichtung läßt sich sowohl so auslegen, daß sie nach dem Schwerkraftprinzip arbeitet, wie auch als System mit Hydrostatik-Stellzylinder. Außerdem können bei der Einrichtung zusätzlich die Merkmale eines beliebigen der Ansprüche 1 bis 6 vorgesehen sein.

Bei einer solchen kombinierten Nachführeinrichtung ist in Weiterbildung der Erfindung nach Anspruch 8 vorgesehen, das Feineinstellreflektorelement auf der drehachsenzugewandten Seite der zugehörigen Absorbereinheit und im Abstand dazu das Grobeinstellreflektorelement gegenüberliegend auf der drehachsenabgewandten Seite so anzuordnen, daß das der Absorbereinheit zugeordnete Rückholreflektorelement das von der Nutzelementrückseite einfallende Sonnenlicht durch den Zwischenraum zwischen Feineinstellreflektorelement und Grobeinstellreflektorelement auf die betreffende Absorbereinheit reflektiert. Die so weitergebildete Einrichtung läßt sich relativ kompakt bauen und besitzt sowohl eine hohe Nachführgenauigkeit als auch die Fähigkeit zur Rückholung in die Sollposition aus allen praktisch bedeutsamen Fehlwinkelstellungen.

Ein vorteilhaftes Ausführungsbeispiel der Erfindung ist in den Zeichnungen dargestellt und wird nachfolgend beschrieben. Hierbei zeigen:
- Fig. 1: eine schematische Seitenansicht eines Sonnenkollektors mit thermohydraulischer Sonnennachführeinrichtung nach dem Schwerkraftprinzip,
- Fig. 2: ein Simulationsdiagramm der Bestrahlungsintensität eines der Absorberrohre der Nachführeinrichtung von Fig. 1 in Abhängigkeit vom Fehlwinkel,
- Fig. 3: ein Diagramm entsprechend Fig. 2, jedoch detailliert für einen Bereich kleiner Fehlwinkel,
- Fig. 4: eine schematische Seitenansicht eines Absorberelementes mit zugehörigem Feineinstellreflektorelement zur Verdeutlichung der das Diagramm von Fig. 3 ergebenden Bestrahlungsverhältnisse,
- Fig. 5 bis 12: schematische Seitenansichten entsprechend Fig. 1 in verschiedenen Fehlstellungen mit zunehmendem Fehlwinkel zur Veranschaulichung der Nachführfunktionalität.

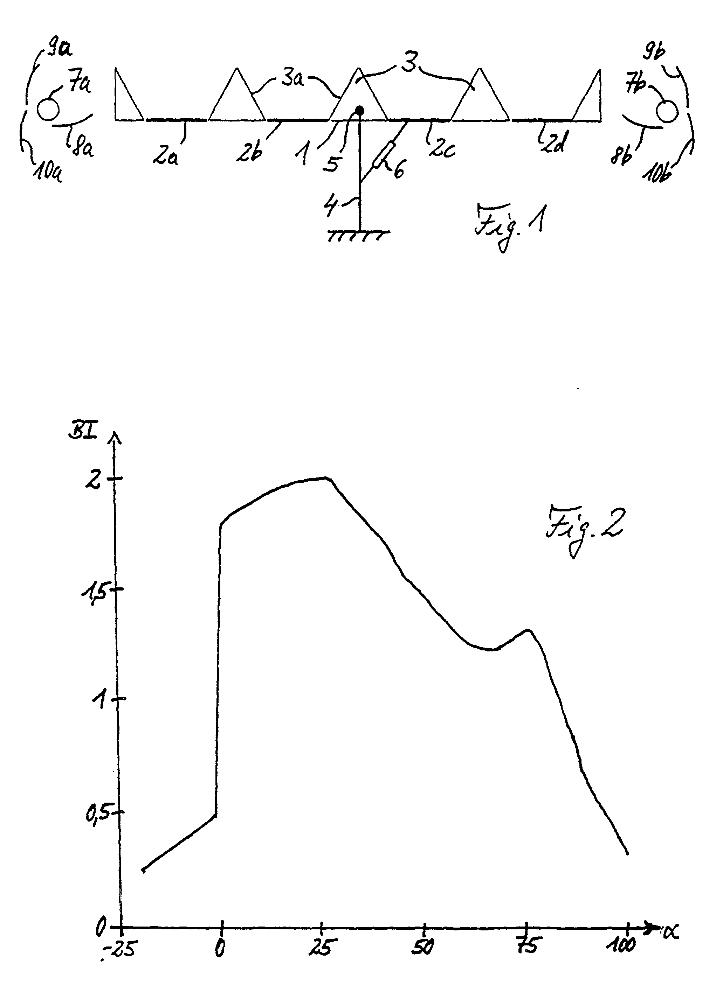

Fig. 1 zeigt schematisch eine Photovoltaikeinheit mit einem Sonnennutzelement in Form eines Sonnnenkollektors 1 vom Konzentratortyp, der mehrere in einer Ebene voneinander beabstandete, photovoltaisch aktive Elemente 2a bis 2d aufweist, zwischen denen sich im Querschnitt dreieckförmige Reflektorelemente 3 befinden. Diese Reflektorelemente 3 erstrecken sich von der Ebene der photovoltaisch aktiven Elemente 2a bis 2d an der Sonnenlichtnutzseite des Sonnenkollektors 1 nach vorn, d.h. in Fig. 1 nach oben. Sie bilden dabei Lichteinfangtröge mit schrägen Reflektorflächen 3a als Trogwände, die senkrecht von der Sonnenkollektor-Nutzseite her einfallendes Sonnenlicht auf die photovoltaisch aktiven Elemente 2a bis 2d reflektieren und damit konzentrieren. Der Sonnenkollektor 1 ist an einem vertikalen Tragpfosten 4 um eine Drehachse 5 schwenkbeweglich gelagert. Ein Zylinderkolben 6 dient der Dämpfung insbesondere von schnellen Drehbewegungen und damit der Stabilisierung gegenüber Windlasten. Gleichzeitig kann der Zylinderkolben 6 zur Festlegung der Endanschläge des Schwenkbereichs für den Sonnenkollektor 1 dienen. Zusätzlich oder alternativ hierzu kann dieser Schwenkbereich, von nicht gezeigten, mechanischen Anschlägen gebildet sein, gegen die der Sonnenkollektor 1 vorzugsweise in einem äußeren Bereich zur Anlage kommt. Selbstverständlich ist statt des gezeigten Sonnenkollektors 1 jeder andere Sonnenkollektortyp oder irgendein anderes, das einfallende Sonnenlicht nutzendes Element einsetzbar.

Der insoweit konventionellen Sonnenkollektoranordnung ist eine neuartige thermohydraulische Sonnennachführeinrichtung zugeordnet. Die Nachführeinrichtung beinhaltet in an sich herkömmlicher Weise je ein Absorberrohr 7a, 7b an den sich bezüglich der Drehachse 5 gegenüberliegenden Seiten des Sonnenkollektors 1, die über nicht gezeigte Fluidleitungen miteinander in Fluidverbindung stehen. Der so gebildete Fluidkreislauf ist wenigstens teilweise mit einem geeigneten Arbeitsfluid gefüllt, das sich bei Sonnenlichteinfall auf das jeweilige Absorberrohr 7a, 7b an der betreffenden Stelle erwärmt und ausdehnt, so daß Bestrahlungsunterschiede zwischen den beiden Absorberrohren 7a, 7b zu entsprechenden Arbeitsfluiddruckdifferenzen führen. Diese bewirken bei Schwerkraftsystemen direkt einen Transport von Arbeitsfluid vom stärker bestrahlten zum anderen Adsorberrohr und bei Systemen mit Hydrostatik-Stellzylinder eine Betätigung des dortigen Stellkolbens, was jeweils zu einem rückstellenden Drehmoment auf den Sonnenkollektor 1 führt. Dabei können alternativ zu den gezeigten Absorberrohren auch andersartige Absorbereinheiten verwendet werden, z.B. solche, die aus je einem Arbeitsfluidspeicher und einem davon räumlich getrennten, jedoch mit ihm in wärmeleitender Verbindung stehenden Absorberelement bestehen. Wesentlich ist für Schwerkraftsysteme jeweils nur, daß der das Arbeitsfluid speichernde Teil der Absorbereinheit kraftübertragend mit der betreffenden Seite des Sonnenkollektors 1 gekoppelt ist, damit die Schwerkraft des dort gespeicherten Arbeitsfluides in der gewünschten Weise auf den Sonnenkollektor 1 wirkt. Nachfolgend wird die Einrichtung von Fig. 1 in einer Auslegung als Schwerkraftsystem beschrieben, sie kann jedoch bei geeigneter Zwischenschaltung eines Hydrostatik-Stellzylinders in die Verbindungsleitung der beiden Absorberrohre 7a, 7b genauso gut als Stellzylindersystem ausgelegt werden.

Charakteristischerweise beinhaltet die Nachführeinrichtung eine Lichtsteuereinheit, die für jedes Absorberrohr 7a, 7b einen Feineinstellreflektor 8a, 8b, einen Grobeinstellreflektor 9a, 9b und einen Rückholreflektor 10a, 10b beinhaltet. Jedes dieser drei Reflektorpaare 8a bis 10b ist spiegelsymmetrisch zu der Sonnenkollektormittelebene angeordnet, die senkrecht zur Ebene der photovoltaisch aktiven Elemente 2a bis 2d steht. Die Reflektoren 8a bis 10b sind ebenso wie die Absorberrohre 7a, 7b in nicht näher gezeigter, herkömmlicher Weise entlang der jeweils zugewandten Seitenkante des Sonnenkollektors 1 fest angebracht und verschwenken sich daher zusammen mit den Absorberrohren 7a, 7b gemeinsam mit dem Sonnenkollektor 1.

Die drei verschiedenen Reflektorpaare 8a bis 10b sind zur Erfüllung jeweils einer speziell zugewiesenen Funktion in spezifischer Weise geformt und angeordnet, wie aus Fig. 1 zu erkennen. Insbesondere liegen die beiden Feineinstellreflektoren 8a, 8b schräg unterhalb des jeweiligen Absorberrohres 7a, 7b auf dessen drehachsenzugewandter Seite, während die beiden Grobeinstellreflektoren 9a, 9b schräg oberhalb des jeweiligen Absorberrohres 7a, 7b auf dessen der Drehachse 5 abgewandter Seite positioniert sind. Die beiden Rückholreflektoren 10a, 10b liegen etwa unterhalb des jeweiligen Grobeinstellreflektors 9a, 9b und erstrecken sich dabei von der Ebene der photovoltaisch aktiven Elemente 2a bis 2d aus nach unten über das Niveau der Feineinstellreflektoren 8a, 8b hinaus, die ihrerseits etwa auf der Ebene der photovoltaisch aktiven Elemente 2a bis 2d liegen.

Mit dieser speziellen Anordnung der drei Reflektoren 8a bis 10b für jedes Absorberrohr 7a, 7b ergibt sich eine hinsichtlich Nachführgenauigkeit und Ostrückführung bzw. Westhinführung besonders vorteilhafte Sonnenlichteinstrahlcharakteristik auf die Absorberrohre 7a, 7b in Abhängigkeit vom Fehlwinkel α, d.h. dem Winkel, um den der Sonnenkollektor 1 von seiner Sollposition abweicht. Letztere ist als die optimale Sonnenlichteinfangposition dadurch definiert, daß in dieser Stellung das Sonnenlicht senkrecht zur Ebene der photovoltaischen Elemente 2a bis 2d von der Nutzseite her einfällt.

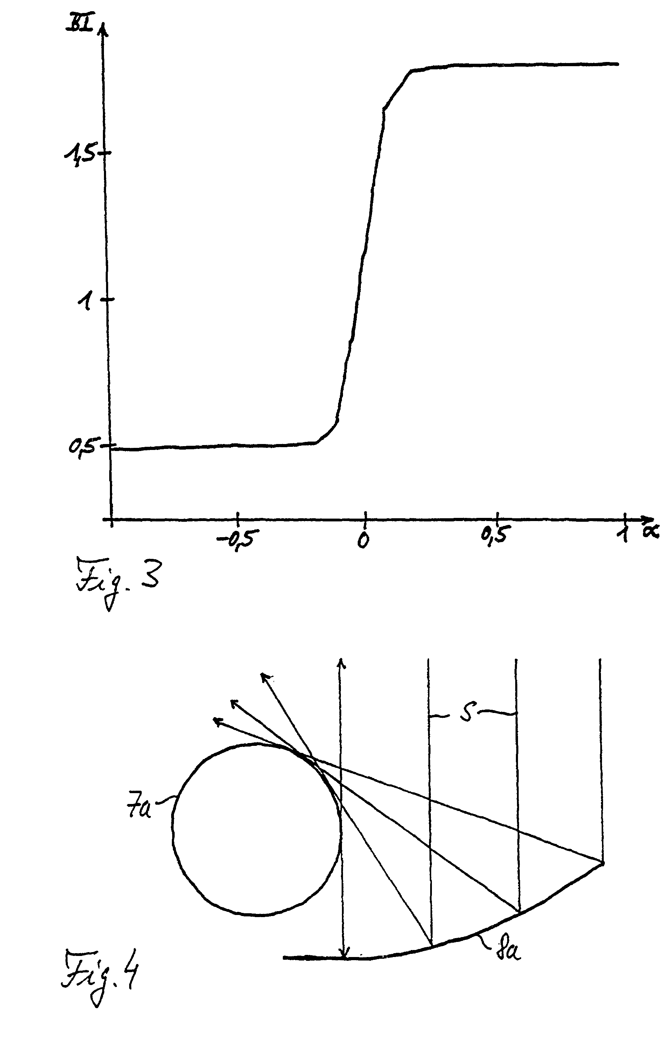

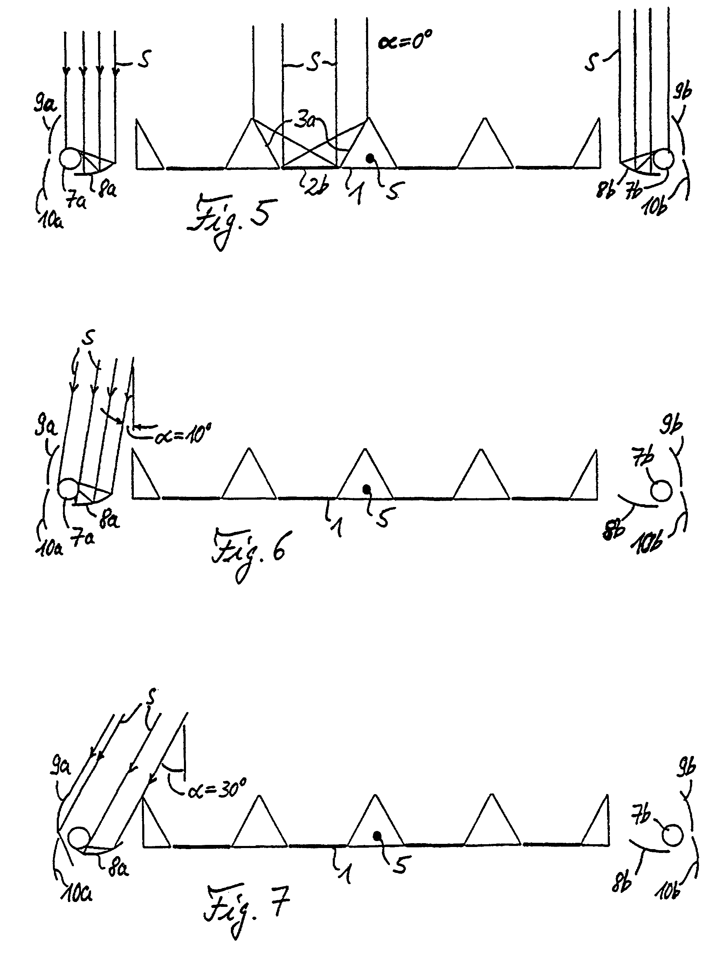

Fig. 2 zeigt den aus einer Rechnersimulation unter der idealisierten Annahme einer Punktlichtquelle erhaltenen Kurvenverlauf der Bestrahlungsintensität BI in Abhängigkeit vom Fehlwinkel α für das sonnenabgewandt verschwenkte Absorberrohr über einen Fehlwinkelbereich von etwa -20° bis +100°. Wie aus Fig. 2 ersichtlich, tritt für größere negative Fehlwinkelwerte, d.h. für ein sonnenzugewandtes Verschwenken des betrachteten Absorberrohres, eine Reduzierung der Bestrahlungsintensität BI auf, die daraus resultiert, daß der zugeordnete Grobeinstellreflektor 9a, 9b als Abschattelement wirkt und das sonnenzugewandt verschwenkte Absorberrohr zunehmend vor direktem Sonnenlichteinfall abschattet. Gleichzeitig wird, wie im weiteren deutlich wird, kein Sonnenlicht von den beiden anderen Reflektoren 8a, 10a, bzw. 8b, 10b auf das Absorberrohr 7a, 7b reflektiert. Bei sonnenabgewandtem Herausbewegen tritt mit Durchschreiten der Sollposition innerhalb eines sehr kleinen Fehlwinkelbereichs α eine scharfe Erhöhung der Bestrahlungsintensität BI mit entsprechend hohem Gradienten auf, wonach dann die Bestrahlungsintensität BI über einen Fehlwinkelbereich von mindestens etwa 50° signifikant hoch bleibt, d.h. über dem Eineinhalbfachen der Normintensität, die für eine direkte, volle Absorberrohrbestrahlung gilt und auf welche die Bestrahlungsintensität BI in den Diagrammen der Figuren 2 und 3 normiert ist. Erst bei Fehlwinkeln von mehr als etwa 80° fällt die Bestrahlungsintensität BI unter die Normintensität ab.

Fig. 3 zeigt detaillierter den sehr raschen Anstieg der Bestrahlungsintensität BI unmittelbar beim Durchschreiten aus der Sollposition. Wie aus Fig. 3 zu erkennen, steigt die Bestrahlungsintensität BI von etwa der halben Normintensität bei Fehlwinkeln bis zu etwa -0,1° auf etwa das 1,75-fache bei Fehlwinkeln von +0,1° und darüber an. Dies bedeutet, daß der in der Sollposition vorliegende Intensitätsgradient in der Größenordnung von 6/Grad liegt, was einen gegenüber herkömmlichen Systemen deutlich höheren Wert darstellt, der somit eine entsprechend hohe Nachführgenauigkeit in diesem engen Feineinstellbereich erlaubt, der sich höchstens über einige wenige Winkelgerade und vorzugsweise nur über einige wenige zehntel Winkelgrade erstreckt. In der Praxis wird der gezeigte scharfe Gradientenanstieg, wie er von der Simulation geliefert wird, wegen des Öffnungswinkels der Sonne von ca. 0,5° etwas verschwommener sein, dies ändert aber nichts an den obigen Aussagen über die auch damit noch erzielbare hohe Nachführgenauigkeit.

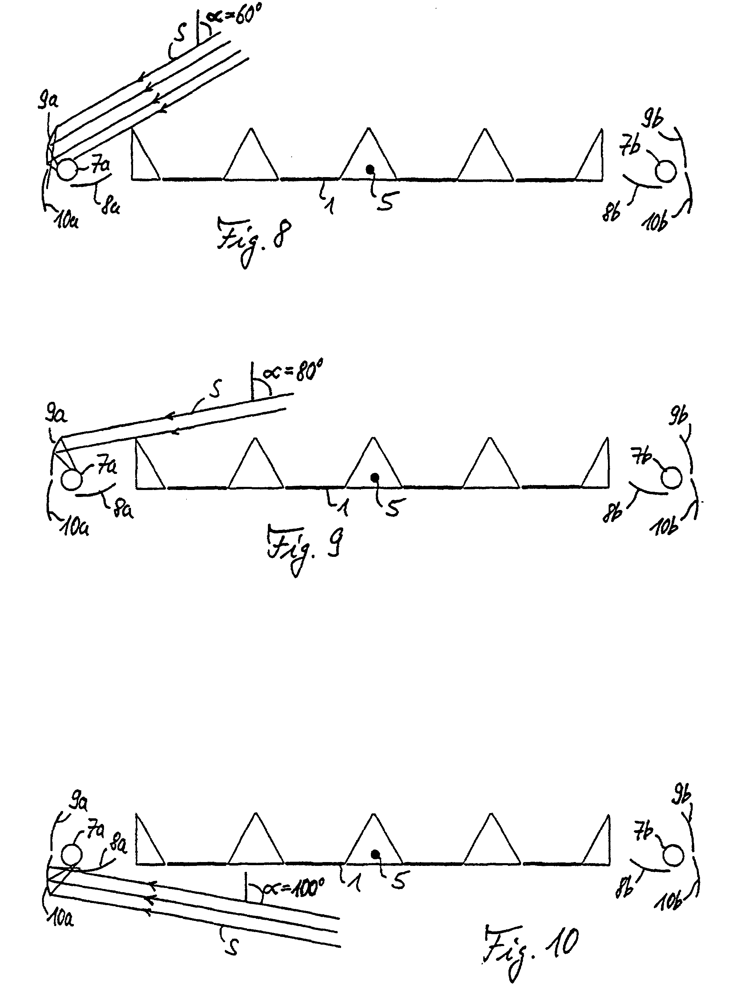

Diese Feineinstellwirkung wird primär von den Feineinstellreflektoren 8a, 8b bewirkt, die dazu speziell ausgelegt sind. Fig. 4 veranschaulicht deren Wirkungsweise am Beispiel eines Feineinstellreflektors 8a mit zugehörigem Absorberrohr 7a, wobei die Anordnung in der Sonnenkollektor-Sollposition gezeigt ist. Das dann mit dem Fehlwinkelwert null einfallende Sonnenlicht S wird, soweit es auf den jeweiligen Feineinstellreflektor 8a fällt, von diesem so reflektiert, daß es anschließend das zugehörige Absorberrohr 7a tangential streift. Dazu ist der Feineinstellreflektor 8a in seiner Form und seiner relativen Anordnung gegenüber dem Absorberrohr 7a geeignet auf die Absorberrohrgestalt abgestimmt, die im gezeigten Beispiel von kreisrundem Querschnitt ist, alternativ jedoch auch einen anderen Querschnitt haben kann.

Wenn nun ausgehend von dieser Sollposition der Feineinstellreflektor 8a samt zugehörigem Absorberrohr 7a sonnenzugewandt verschwenkt wird, d.h. die Sonnenstrahlen S fallen dann in Fig. 4 schräg von rechts oben nach links unten auf den Feineinstellreflektor 8a, so reflektiert der Feineinstellreflektor 8a die auf ihn auftreffenden Sonnenstrahlen S vollständig vom Absorberrohr 7a weg, und zwar schon bei einem sehr geringen Fehlwinkel von etwa -0,1°. Dies erklärt den scharfen Abfall der Bestrahlungsintensität BI in Fig. 3 bei geringem Verschwenken aus der Sollposition zu negativen Fehlerwinkelwerten. Wenn andererseits der Feineinstellreflektor 8a ausgehend von der Sollposition in Fig. 4 samt Absorberrohr 7a sonnenabgewandt verschwenkt wird, d.h. das Sonnenlicht S fällt dann in Fig. 4 schräg von links oben nach rechts unten auf den Feineinstellreflektor 8a, so wirft der Feineinstellreflektor 8a das gesamte, von ihm reflektierte Licht auf das Absorberrohr 7a, und zwar schon bei einem sehr geringen Fehlwinkel von ca. 0,1°. Der scharfe Gradient der Bestrahlungsintensität BI wird folglich unter Verwendung des Feineinstellreflektors 8a dadurch ermöglicht, daß dieser so ausgelegt ist, daß er in der Sonnenkollektor-Sollposition alle auf ihn einfallenden Sonnenstrahlen im wesentlichen tangential zum zugehörigen Absorberrohr 7a reflektiert.

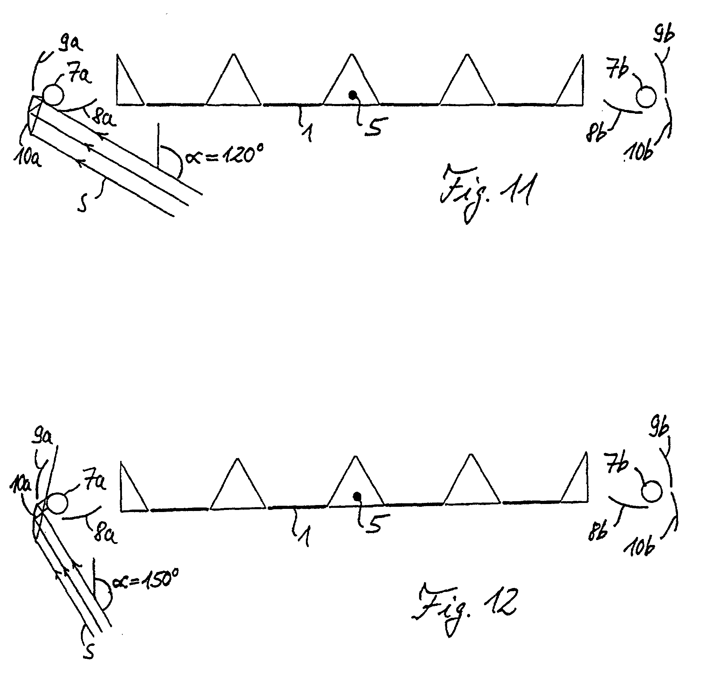

Durch die spiegelsymmetrische Anordnung der beiden Feineinstellreflektoren 8a, 8b unterstützen sich diese in ihrer Feineinstellwirkung, indem beim Herausschwenken des Sonnenkollektors 1 aus der Sollposition in jede der beiden Drehrichtungen der sonnenabgewandt verschwenkte Feineinstellreflektor die Bestrahlungsintensität für das zugehörige Absorberrohr stark erhöht, während gleichzeitig der andere, sonnenzugewandt verschwenkte Feineinstellreflektor das auf ihn einfallende Sonnenlicht vollständig am anderen Absorberrohr vorbeireflektiert und so keine weitere Erwärmung desselben verursacht. Durch die beschriebene Auslegung der feineinstellenden Nachführung derart, daß das sonnenabgewandt verschwenkte Absorberrohr stärker als das sonnenzugewandt verschwenkte Absorberrohr bestrahlt wird, eignet sich die Einrichtung unmittelbar zur Nachführung nach dem Schwerkraftprinzip. Durch die Verwendung der Grobeinstellreflektoren 9a, 9b und der Rückholreflektoren 10a, 10b zusätzlich zu den Feineinstellreflektoren 8a, 8b wird eine Rückführung des Sonnenkollektors 1 auch bei größeren Fehlwinkeln zuverlässig sichergestellt, insbesondere in einem Grobwinkelbereich bis zu Fehlwinkeln von etwa 90° und vorteilhafterweise auch in einem Rückholwinkelbereich mit Fehlwinkelstellungen von mehr als 90°, bei denen der Sonnenkollektor 1 rückwärtig beschienen wird. Das Zusammenwirken der einzelnen Reflektoren 8a bis 10b zur Erzielung dieser zuverlässigen Nachführung über den gesamten, praktisch bedeutsamen Schwenkwinkelbereich des Sonnenkollektors 1 hinweg ist in den Fig. 5 bis 12 veranschaulicht.

Fig. 5 zeigt die Situation in der Sollposition des Sonnenkollektors 1, in welchem das Sonnenlicht S parallel zur Senkrechten der Kollektorebene einfällt. Im mittleren Bereich von Fig. 5 ist die Konzentratorwirkung des Sonnenkollektors 1 angedeutet, wonach vom jeweiligen photovoltaisch aktiven Element 2b nicht nur das direkt einfallende Sonnenlicht genutzt wird, sondern zusätzlich das darauf von den schrägen Trogreflektorflächen 3a reflektierte Licht. Auf diese Weise kann das gesamte, auf die Kollektorgrundfläche einfallende Licht photovoltaisch genutzt werden, ohne daß der Kollektor 1 selbst ganzflächig mit den photovoltaisch aktiven Elementen belegt sein muß. In der Sollposition von Fig. 5 fällt das Sonnenlicht S symmetrisch auf die beiden Hälften der Nachführeinrichtung ein, so daß beide Absorberrohre 7a, 7b gleich stark erwärmt werden, zu einem Teil durch direkt einfallendes Licht und im übrigen durch das von den Feineinstellreflektoren 8a, 8b streifend reflektierte Licht. Gleichzeitig sorgen die Grobeinstellreflektoren 9a, 9b in dieser Stellung für eine partielle Abschattung der Absorberrohre 7a, 7b.

Fig. 6 veranschaulicht die Situation für eine Fehlstellung mit einem Fehlwinkel von α=10°, unter dem das Sonnenlicht S nun schräg zur Kollektornormalenrichtung einfällt. Wie oben erläutert, reflektiert in dieser Stellung der sonnenabgewandt verschwenkte Feineinstellreflektor 8a das gesamte, auf ihn einfallende Sonnenlicht auf das zugehörige Absorberrohr 7a. Gleichzeitig gibt der dortige Grobeinstellreflektor 9a das Absorberrohr 7a vollständig für direkten Sonnenlichteinfall frei. Im Gegensatz dazu reflektiert auf der gegenüberliegenden Seite der Feineinstellreflektor 8b das Licht vollständig am zugehörigen Absorberrohr 7b vorbei, und gleichzeitig schattet der dortige Grobeinstellreflektor 9b das Absorberrohr 7b praktisch vollständig gegen direkten Sonnenlichteinfall ab. Der Übersichtlichkeit halber sind diese ohne weiteres einsichtigen Sonnenstrahlverläufe auf der sonnenzugewandt verschwenkten Seite in Fig. 6 und in weiteren Fig. 7 bis 12 nicht im Detail gezeichnet. Durch die asymmetrische Absorberrohrbestrahlung wird somit das sonnenabgewandt verschwenkte Absorberrohr 7a stärker erwärmt als das sonnenzugewandt verschwenkte, gegenüberliegende Absorberrohr 7b, was einen Arbeitsfluidtransport vom sonnenabgewandt zum sonnenzugewandt verschwenkten Absorberrohr zur Folge hat. Diese Gewichtsverlagerung des Arbeitsfluides erzeugt das gewünschte Rückstelldrehmoment für den Sonnenkollektor 1 um seine Drehachse 5.

Fig. 7 zeigt das System in einer Fehlwinkelstellung von α=30°. Auf der sonnenabgewandt verschwenkten Seite reflektiert der Feineinstellreflektor 8a noch immer praktisch das gesamte, auf ihn einfallende Sonnenlicht auf das Absorberrohr 7a, während auf der gegenüberliegenden, sonnenzugewandt verschwenkten Seite das dortige Absorberrohr 7b weiterhin nicht von reflektiertem Licht des Feineinstellreflektors 8b getroffen und gegenüber direktem Lichteinfall vom Grobeinstellreflektor 9b abgeschattet wird. Auch in dieser Fehlstellung ergibt sich folglich eine stärkere Erwärmung des sonnenabgewandt verschwenkten Absorberrohres 7a und damit das gewünschte Kollektorrückstellmoment.

Fig. 8 zeigt das System unter einem Fehlstellungswinkel von α=60°. Auf der sonnenabgewandt verschwenkten Seite ist der Feineinstellreflektor 8a nun nicht mehr wirksam, da er vom Sonnenkollektor 1 abgeschattet wird. Im Bereich zwischen der Fehlstellung gemäß Fig. 8 und derjenigen gemäß Fig. 7 übernimmt jedoch sukzessive der Grobeinstellreflektor 9a die Funktion der konzentrierenden Absorberrohrbestrahlung, indem er beginnend mit einem Fehlwinkel von ca. 30° mit höherem Fehlwinkel zunehmend Licht an seiner reflektierenden und konzentrierend gekrümmten Vorderseite empfängt und dieses weitgehend vollständig auf das zugehörige Absorberrohr 7a reflektiert. Auf der gegenüberliegenden, sonnenzugewandt verschwenkten Seite bleibt das dortige Absorberrohr 7b weiterhin vom Grobeinstellreflektor 9b vollständig abgeschattet, wobei nun auch der dortige Feineinstellreflektor 8b abgeschattet wird. Insgesamt bewirkt daher bei Fehlwinkelstellungen ab etwa α=30° der sonnenabgewandt verschwenkte Grobeinstellreflektor 9a die stärkere Erwärmung des zugehörigen Absorberrohres 7a gegenüber dem anderen Absorberrohr 7b, wodurch weiterhin ein schwerkraftbedingtes Kollektorrückstellmoment bereitgestellt wird.

Diese Verhältnisse sind auch noch für Fehlwinkel von mehr als 60°, jedoch kleiner als 90°, gegeben, was durch Fig. 9 veranschaulicht ist, in der das System mit einem Fehlstellungswinkel von α=80° wiedergegeben ist. Zwar wird hier der sonnenabgewandt verschwenkte Grobeinstellreflektor 9a schon teilweise durch den Sonnenkollektor 1 abgeschattet, er empfängt jedoch noch Sonnenlicht in einem oberen Abschnitt, das er auf das Absorberrohr 7a reflektiert. Hingegen bleibt das gegenüberliegende, sonnenzugewandt verschwenkte Absorberrohr 7b weiterhin vollständig abgeschattet, so daß sich auch hier noch eine Rückstellwirkung ergibt.

Zwischen der Situation von Fig. 9 und derjenigen von Fig. 10, die das System mit einem Fehlwinkel von α=100° zeigt, durchläuft das System einen Totwinkelbereich, der jedoch wegen seiner geringen Winkelerstreckung nicht merklich stört. Während in den Fig. 5 bis 9 der Sonneneinfall an der Kollektorvorderseite erfolgt, veranschaulichen die Fig. 10 bis 12 Situationen, bei denen das Sonnenlicht zunehmend von hinten auf den Sonnenkollektor 1 einfällt. Hier werden nun die zuvor inaktiven Rückholreflektoren 10a, 10b aktiv. Wie aus Fig. 10 ersichtlich, reflektiert der sonnenabgewandt verschwenkte Rückholreflektor 10a das kollektorrückseitig auf ihn einfallende Sonnenlicht S durch den zwischen Feineinstellreflektor 8a und Grobeinstellreflektor 9a gebildeten Zwischenraum hindurch auf das zugehörige Absorberrohr 7a. Hingegen schattet auf der gegenüberliegenden Seite der dortige Rückholreflektor 10b das Absorberrohr 7b vor Sonnenlichteinfall ab, und auch von den beiden anderen Reflektoren 8b, 9b erfolgt keine Lichtreflexion auf das Absorberrohr 7b.

Folglich wird auch in diesen um mehr als 90° gekippten, rückwärtigen Fehlstellungen weiterhin das sonnenabgewandt verschwenkte Absorberrohr 7a stärker bestrahlt als das Sonnenzugewandt verschwenkte Absorberrohr 7b, so daß sich auch hier das gewünschte Rückstellmoment ergibt. Es ist an dieser Stelle anzumerken, daß das in den rückwärts bestrahlten Situationen gemäß den Fig. 10 bis 12 erzeugte Rückstellmoment aufgrund der bekanntermaßen hohen Trägheit dieser Systeme ohne weiteres ausreicht, den erwähnten Totwinkelbereich zwischen den Stellungen der Fig. 10 und 9 zu überfahren, ohne daß das System dort stehenbleibt. Damit wird eine zuverlässige, morgendliche Ostrückführung aus abendlichen Weststellungen ebenso ermöglicht wie eine zuverlässige Westhinführung um Nachstellwinkel größer als 90° bei im Tagesverlauf längeren Unterbrechnungen der Sonneneinstrahlung.

Fig. 11 zeigt das System in einer rückwärtig einstrahlenden Fehlstellung von α=120°. Wie daraus ersichtlich, wird der sonnenabgewandt verschwenkte Rückholreflektor 10a nun ganzflächig von einfallendem Sonnenlicht S bestrahlt und reflektiert dieses vollständig auf das zugehörige Absorberrohr 7a. Auf der gegenüberliegenden Seite bleibt das Absorberrohr 7b weiterhin vom Rückholreflektor 10b abgeschattet. Es ergibt sich wiederum ein hohes rückstellendes Moment auf den Sonnenkollektor 1.

Fig. 12 zeigt das System in einer rückwärts einstrahlenden Fehlstellung von α=150°. Höhere Fehlstellungswinkel tauchen in der Praxis kaum auf, da eine Solarnachführung über einen Winkelbereich von 150° meistens völlig ausreichend ist und eine darüber hinausgehende Verschwenkbarkeit des Sonnenkollektors 1 keine merkliche Erhöhung der Sonnenenergieausbeute mehr erbringt. Auch in dieser extremen Fehlstellung von Fig. 12 reflektiert der sonnenabgewandt verschwenkte Rückholreflektor 10a noch einen merklichen Anteil an einfallendem Sonnenlicht auf das zugehörige Absorberrohr 7a. Auf der gegenüberliegenden Seite bleibt das Absorberrohr 7b großteils durch die Abschattwirkung des Rückholreflektors 10b abgeschattet und wird allenfalls geringfügig direkt bestrahlt. Diese Direktbestrahlung ist jedoch weit geringer als die auf der sonnenabgewandt verschwenkten Seite vom dortigen Rückholreflektor 10a bewirkte, konzentrierte Absorberrohrbestrahlung, so daß nach wie vor thermohydraulisch selbsttätig ein rückstellendes Moment auf den Sonnenkollektor 1 ausgeübt wird. Dies gilt im übrigen auch in schwächer werdendem Maß für noch höhere Fehlwinkel, während erst beim theoretischen Fehlwinkel von 180° eine instabile Gleichgewichtslage vorliegt.

Die obige Beschreibung eines vorteilhaften Beispiels zeigt, daß mit der erfindungsgemäßen Einrichtung ein beliebiges Sonnennutzelement mit sehr hoher Genauigkeit optimal zur Sonne ausgerichtet und dem sich verändernden Sonnenstand nachgeführt werden kann und dabei insbesondere auch aus stark verkippten Fehlstellungen, einschließlich solchen mit rückwärtiger Sonneneinstrahlung auf das Sonnennutzelement, in die optimale Sollposition zurückgeführt werden kann. Die Sollposition des Sonnennutzelementes richtet sich nach dessen Typ. So liegt sie für ein Sonnenkollektorelement wie im gezeigten Beispiel derart, daß das Sonnenlicht möglichst senkrecht auf die Kollektorflächen einfällt. Bei einem Sonnennutzelement in Form eines Sonnenlichtreflektors, wie er z.B. zur Sonnenlichtumlenkung an eine entfernte Weiternutzungsstelle, wie einem zentralen "Solarturm", oder zur gezielten Sonnenlichtlenkung in der Architektur verwendet wird, liegt hingegen die Sollposition zweckentsprechend so, daß die gewünschte Lichtführung erreicht wird, d.h. die Reflektorflächennormale verläuft schräg zur Sonneneinfallsrichtung als Winkelhalbierende zwischen Einfalls- und Ausfallsrichtung des Sonnenlichtes. Es zeigt sich, daß für die Rückhol- und die Grobeinstellreflektoren dieselbe Formgebung verwendbar ist, wie die in Fig. 4 beschriebene Formgebung der Feineinstellreflektoren, was den fertigungstechnischen Vorteil hat, daß nur ein einziger Reflektorbautyp erforderlich ist. Alternativ sind unterschiedliche Formgebungen für die einzelnen Reflektoren verwendbar.

Es versteht sich, daß je nach Anwendungsfall Modifikationen des gezeigten Beispiels realisierbar sind. So kann bei einer Auslegung als Stellzylindersystem die Positionierung des jeweiligen Absorberrohres samt Lichtsteuereinheit beliebig gewählt sein, solange keine störenden Abschatteffekte auftreten und die oben beschriebenen Funktionsprinzipien weitergelten. Insbesondere können dann die beiden Absorberrohre z.B. axial versetzt in einer Reihe auf einer Seite der Anordnung der Sonnennutzelemente liegen. Des weiteren kann das System je nach Anwendungsfall so ausgelegt sein, daß sich die Lichtsteuereinheit mit dem Absorberrohr mit demselben Winkel verschwenkt wie das Sonnennutzelement oder aber um einen davon verschiedenen, z.B. nur um den halben Schwenkwinkel, letzteres besonders in dem Fall eines Sonnenlichtreflektors als Sonnennutzelement. Weiter kann, da stets einer der beiden Rückholreflektoren für die Ostrückführung und der andere für die Westhinführung maßgeblich ist, einer der beiden Rückholreflektoren entfallen, wenn auf die betreffende Funktion verzichtet werden kann. Wenn gewünscht, kann auch auf beide Rückholreflektoren verzichtet werden, was sich für Systeme anbietet, bei denen keine rückwärts einstrahlenden Fehlwinkelstellungen drohen. Analog dazu kann auf einen oder beide Feineinstellreflektoren 8a, 8b verzichtet werden, wenn die von diesen bewirkte Feineinstellgenauigkeit nicht erforderlich, dafür aber die Rückholfunktion eines oder beider Rückholreflektoren gewünscht ist. Gleichermaßen kann in speziellen Fällen auf einen oder beide Grobeinstellreflektoren verzichtet werden.

Es versteht sich außerdem, daß der Sonnenkollektor bei Bedarf nicht nur, wie gezeigt, um die eine Drehachse 5, sondern zusätzlich um eine dazu vorzugsweise senkrechte, weitere Drehachse schwenkbeweglich nachführbar gelagert sein kann. Die Nachführung um diese weitere Drehachse kann konventionell oder unter Verwendung entsprechender Nachführkomponenten erfolgen, wie sie oben zur gezeigten Drehachse 5 beschrieben sind. Weiter versteht sich, daß der Feineinstellreflektor und der zugehörige Grobeinstellreflektor nicht nur als getrennte Bauelemente realisiert, sondern bei Bedarf in ein gemeinsames Bauteil integriert sein können. Dieses besitzt dann zwischen Grob- und Feineinstellreflektorabschnitt einen transparenten Abschnitt, durch den das vom Rückholreflektor reflektierte Licht auf das betreffende Absorberrohr hindurchgelangt.

## Patentansprüche

1. Thermohydraulische Sonnennachführeinrichtung für ein um wenigstens eine Drehachse (5) schwenkbares Sonnennutzelement (1), mit
- zwei Absorbereinheiten (7a, 7b), die jeweils ein durch Sonnenlichteinfall auf die Absorbereinheit erwärmbares Arbeitsfluid zur Erzeugung nachführender Stellkräfte für das Sonnennutzelement beinhalten, und
- einer lichtreflektierenden und/oder lichtabschattenden Lichtsteuereinheit (8a bis 10b), die sich sonnenstandsabhängig verschwenkt und in einer Nutzelement-Sollposition eine im wesentlichen symmetrische sowie bei Herausbewegen aus der Sollposition eine verschieden hohe Sonnenlichtbestrahlung der Absorbereinheiten bewirkt,
**dadurch gekennzeichnet, daß**
- die Lichtsteuereinheit für wenigstens eine Absorbereinheit (7a, 7b) ein sich sonnenstandsabhängig verschwenkendes Feineinstellreflektorelement (8a, 8b) aufweist, welches einfallendes Sonnenlicht innerhalb eines die Nutzelement-Sollposition enthaltenden Feineinstellbereiches von höchstens 4° in einem ersten Bereichsendpunkt im wesentlichen tangential zur zugehörigen Absorbereinheit und bis zum anderen Bereichsendpunkt zunehmend auf die zugehörige Absorbereinheit reflektiert.

2. Sonnennachführeinrichtung nach Anspruch 1, weiter **dadurch gekennzeichnet, daß** das Feineinstellreflektorelement (8a, 8b) in einer um höchstens 0,5° gegenüber der Nutzelement-Sollposition verschwenkten Fehlstellung Sonnenlicht in einer Intensität auf die zugehörige Absorbereinheit (7a, 7b) reflektiert, die mindestens 50% der sich bei vollständiger direkter Sonneneinstrahlung ergebenden Intensität beträgt.

3. Sonnennachführeinrichtung nach Anspruch 1 oder 2, weiter **dadurch gekennzeichnet, daß** das Feineinstellreflektorelement (8a, 8b) die Sonnenlichtreflexion auf die zugehörige Absorbereinheit (7a, 7b) erhöht, wenn es sich aus der Nutzelement-Sollposition sonnenabgewandt verschwenkt.

4. Sonnennachführeinrichtung nach einem der Ansprüche 1 bis 3, weiter **dadurch gekennzeichnet, daß** die Lichtsteuereinheit für wenigstens eine Absorbereinheit (7a, 7b) ein sich mit dem Sonnennutzelement (1) verschwenkendes Grobeinstellreflektorelement (9a, 9b) aufweist, das einfallendes Sonnenlicht innerhalb eines sich an den Feineinstellwinkelbereich anschließenden oder mit diesem überlappenden Grobeinstellwinkelbereich auf die zugehörige Absorbereinheit (7a, 7b) reflektiert.

5. Sonnennachführeinrichtung nach Anspruch 4, weiter **dadurch gekennzeichnet, daß** sich der Grobeinstellwinkelbereich bis zu einem Fehlwinkel von wenigstens 70° in sonnenabgewandter Schwenkrichtung erstreckt.

6. Sonnennachführeinrichtung nach Anspruch 4 oder 5, weiter **dadurch gekennzeichnet, daß** das Grobeinstellreflektorelement (9a, 9b) bei Herausbewegen aus der Nutzelement-Sollposition in sonnenzugewandter Schwenkrichtung als Abschattelement fungiert.

7. Thermohydraulische Sonnennachführeinrichtung, insbesondere nach einem der Ansprüche 1 bis 6, für ein um wenigstens eine Drehachse (5) schwenkbares Sonnennutzelement (1), mit
- zwei Absorbereinheiten (7a, 7b), die jeweils ein durch Sonnenlichteinfall auf die Absorbereinheit erwärmbares Arbeitsfluid zur Erzeugung nachführender Stellkräfte für das Sonnennutzelement beinhalten, und
- einer lichtreflektierenden und/oder lichtabschattenden Lichtsteuereinheit (8a bis 10b), die sich sonnenstandsabhängig verschwenkt und in einer Nutzelement-Sollposition, eine im wesentlichen symmetrische sowie bei Herausbewegen aus der Sollposition eine verschieden hohe Sonnenlichtbestrahlung der Absorbereinheiten bewirkt,
**dadurch gekennzeichnet, daß**
- die Lichtsteuereinheit für wenigstens eine Absorbereinheit (7a, 7b) ein sich sonnenstandsabhängig verschwenkendes Rückholreflektorelement (10a, 10b) aufweist, das innerhalb eines im Fehlwinkelintervall zwischen 90° und 180° liegenden Rückholwinkelbereichs rückwärtig zum Sonnennutzelement einfallendes Sonnenlicht auf die zugehörige Absorbereinheit reflektiert.

8. Sonnennachführeinrichtung nach Anspruch 7 in Verbindung mit einem der Ansprüche 4 bis 6, weiter **dadurch gekennzeichnet, dass** wenigstens einer Absorbereinheit (7a, 7b) auf seiner drehachsenzugewandten Seite das Feineinstellreflektorelement (8a, 8b) und auf der drehachsenabgewandten Seite das Grobeinstellreflektorelement (9a, 9b) zugeordnet ist, wobei zwischen dem Feineinstellreflektorelement und dem Grobeinstellreflektorelement ein transparenter Zwischenraum verbleibt, durch den hindurch das Rückholreflektorelement (10a, 10b) das nutzelementrückseitig einfallende Sonnenlicht auf die zugehörige Absorbereinheit reflektiert.

## Claims

1. Thermohydraulic solar tracking device for a solar utilisation element (1) that is pivotable about at least one axis of rotation (5), comprising
- two absorber units (7a, 7b) each of which contains operating fluid that can be warmed by sunlight incident on the absorber unit to produce tracking actuating forces for the solar utilisation element, and
- a light-reflecting and/or light-shading light-control unit (8a to 10b) which turns in dependence on the position of the sun and which causes the absorber units to be irradiated with sunlight substantially symmetrically in a desired position of the utilisation element and to differing extents upon movement out of the desired position,
**characterised in that**
- the light-control unit for at least one absorber unit (7a, 7b) has a fine-adjustment reflector element (8a, 8b) which turns in dependence on the position of the sun and which, within a fine-adjustment range of not more than 4° which includes the desired position of the utilisation element, reflects incident sunlight substantially tangentially to the associated absorber unit at a first end point of the range and increasingly onto the associated absorber unit up to the other end point of the range.

2. Solar tracking device according to claim 1, further **characterised in that**, in an incorrect position which is turned through not more than 0.5° in comparison with the desired position of the utilisation element, the fine-adjustment reflector element (8a, 8b) reflects sunlight onto the associated absorber unit (7a, 7b) in an intensity that is at least 50% of the intensity obtained in the case of complete direct solar irradiation.

3. Solar tracking device according to claim 1 or 2, further **characterised in that** the fine-adjustment reflector element (8a, 8b) increases the reflection of sunlight onto the associated absorber unit (7a, 7b) if it turns out of the desired position of the utilisation element and away from the sun.

4. Solar tracking device according to any one of claims 1 to 3, further **characterised in that** the light-control unit for at least one absorber unit (7a, 7b) has a coarse-adjustment reflector element (9a, 9b) which turns with the solar utilisation element (1) and which reflects incident sunlight onto the associated absorber unit (7a, 7b) within a coarse-adjustment angle range which adjoins or overlaps with the fine-adjustment angle range.

5. Solar tracking device according to claim 4, further **characterised in that** the coarse-adjustment angle range extends as far as an error angle of at least 70° in the pivoting direction away from the sun.

6. Solar tracking device according to claim 4 or 5, further **characterised in that**, upon movement out of the desired position of the utilisation element in the pivoting direction towards the sun, the coarse-adjustment reflector element (9a, 9b) acts as a shading element.

7. Thermodynamic solar tracking device, especially according to any one of claims 1 to 6, for a solar utilisation element (1) that is pivotable about at least one axis of rotation (5), comprising
- two absorber units (7a, 7b) each of which contains operating fluid that can be warmed by sunlight incident on the absorber unit to produce tracking actuating forces for the solar utilisation element, and
- a light-reflecting and/or light-shading light-control unit (8a to 10b) which turns in dependence on the position of the sun and which causes the absorber units to be irradiated with sunlight substantially symmetrically in a desired position of the utilisation element and to differing extents upon movement out of the desired position,
**characterised in that**
- the light-control unit for at least one absorber unit (7a, 7b) has a resetting reflector element (10a, 10b) which turns in dependence on the position of the sun and which, within a resetting angle range which lies in an error angle range of from 90° to 180°, reflects sunlight that is incident on the back of the solar utilisation element onto the associated absorber unit.

8. Solar tracking device according to claim 7 in combination with any one of claims 4 to 6, further **characterised in that** the fine-adjustment reflector element (8a, 8b) is associated with at least one absorber unit (7a, 7b) on the side thereof towards the axis of rotation, and the coarse-adjustment reflector element (9a, 9b) is associated therewith on the side thereof remote from the axis of rotation, a transparent gap being formed between the fine-adjustment reflector element and the coarse-adjustment reflector element, through which gap the resetting reflector element (10a, 10b) reflects the sunlight that is incident on the back of the utilisation element onto the associated absorber unit.

## Revendications

1. Dispositif de poursuite solaire thermohydraulique pour un élément d'exploitation solaire (1) orientable au moins autour d'un axe de rotation (5), comprenant
deux unités d'absorbeur (7a, 7b) qui contiennent respectivement un fluide de travail adapté pour être réchauffé par l'incidence de la lumière solaire sur l'unité d'absorbeur afin de générer des puissances de réglage de poursuite pour l'élément d'exploitation solaire, et
une unité de commande de lumière (8a à 10b) réfléchissant la lumière et/ou obscurcissant la lumière, qui est orientée en fonction de la position du soleil et provoque dans une position nominale de l'élément d'exploitation un rayonnement de lumière solaire des unités d'absorbeur essentiellement symétrique et d'intensité différente lorsqu'elle quitte la position nominale,
**caractérisé en ce que**
- l'unité de commande de lumière présente pour au moins une unité d'absorbeur (7a, 7b) un élément à réflecteur à mise au point précise (8a, 8b) orienté en fonction de la position du soleil qui réfléchit la lumière solaire incidente à l'intérieur d'une plage de mise au point précise d'un maximum de 4° incluant la position nominale de l'élément d'exploitation en un premier point d'extrémité de plage essentiellement de façon tangentielle par rapport à l'unité d'absorbeur associée et en augmentant jusqu'à l'autre point d'extrémité de plage sur l'unité d'absorbeur associée.

2. Dispositif de poursuite solaire selon la revendication 1, **caractérisé en outre en ce que** l'élément à réflecteur à mise au point précise (8a, 8b) réfléchit, dans une position incorrecte orientée d'un maximum de 0,5° par rapport à la position nominale de l'élément d'exploitation, la lumière solaire à une intensité sur l'unité d'absorbeur associée (7a, 7b) qui s'élève à au moins 50% de l'intensité résultant d'un rayonnement solaire direct total.

3. Dispositif de poursuite solaire selon la revendication 1 ou 2, **caractérisé en outre en ce que** l'élément à réflecteur à mise au point précise (8a, 8b) augmente la réflexion de la lumière solaire sur l'unité d'absorbeur associée (7a, 7b) quand il est orienté à partir de la position nominale de l'élément d'exploitation détournée du soleil.

4. Dispositif de poursuite solaire selon l'une quelconque des revendications 1 à 3, **caractérisé en outre en ce que** l'unité de commande de lumière présente pour au moins une unité d'absorbeur (7a, 7b) un élément à réflecteur à mise au point approximative (9a, 9b) orienté avec l'élément d'exploitation solaire (1) qui réfléchit la lumière solaire incidente à l'intérieur d'une plage angulaire à mise au point approximative adjacente à la plage angulaire de mise au point précise, ou recouvrant celle-ci, sur l'unité d'absorbeur associée (7a, 7b).

5. Dispositif de poursuite solaire selon la revendication 4, **caractérisé en outre en ce que** la plage angulaire à mise au point approximative s'étend jusqu'à un angle incorrect d'au moins 70° dans la direction d'orientation détournée du soleil.

6. Dispositif de poursuite solaire selon la revendication 4 ou 5, **caractérisé en outre en ce que** l'élément à réflecteur à mise au point approximative (9a, 9b) sert d'élément d'obscurcissement lorsqu'il quitte la position nominale de l'élément d'exploitation dans la direction d'orientation tournée vers le soleil.

7. Dispositif de poursuite solaire thermohydraulique, en particulier selon l'une quelconque des revendications 1 à 6, pour un élément d'exploitation solaire (1) orienté au moins autour d'un axe de rotation (5), comprenant
- deux unités d'absorbeur (7a, 7b) qui contiennent respectivement un fluide de travail adapté pour être réchauffé par l'incidence de la lumière solaire sur l'unité d'absorbeur afin de générer des puissances de réglage de poursuite pour l'élément d'exploitation solaire, et
- une unité de commande de lumière (8a à 10b) réfléchissant la lumière et/ou obscurcissant la lumière, qui est orientée en fonction de la position du soleil et provoque dans une position nominale de l'élément d'exploitation un rayonnement de lumière solaire des unités d'absorbeur essentiellement symétrique et d'intensité différente lorsqu'elle quitte la position nominale,
**caractérisé en ce que**
- l'unité de commande de lumière présente pour au moins une unité d'absorbeur (7a, 7b) un élément à réflecteur de rappel (10a, 10b) orienté en fonction de la position du soleil qui réfléchit à l'intérieur d'une plage angulaire de rappel située dans un intervalle angulaire incorrect entre 90° et 180° la lumière solaire incidente en arrière par rapport à l'élément d'exploitation solaire sur l'unité d'absorbeur associée.

8. Dispositif de poursuite solaire selon la revendication 7 en combinaison avec l'une quelconque des revendications 4 à 6, **caractérisé en outre en ce que** l'élément à réflecteur à mise au point précise (8a, 8b) est associé à au moins une unité d'absorbeur (7a, 7b) sur son côté tourné vers l'axe de rotation, et l'élément à réflecteur à mise au point approximative (9a, 9b) lui est associé sur le côté détourné de l'axe de rotation, un espace transparent restant entre l'élément à réflecteur à mise au point précise et l'élément à réflecteur à mise au point approximative, espace à travers lequel l'élément à réflecteur de rappel (10a, 10b) réfléchit la lumière solaire incidente vers l'arrière de l'élément d'exploitation sur l'unité d'absorbeur associée.
